# EUROPÄISCHE PATENTSCHRIFT

(11) **EP 3 490 352 B1**
(45) Veröffentlichungstag und Bekanntmachung des Hinweises auf die Patenterteilung: **11.11.2020**
(21) Anmeldenummer: 17203568.5
(22) Anmeldetag: 24.11.2017
(51) Int. Cl.: H05K 7/20

(54) **NIEDERSPANNUNGSSCHALTGERÄT MIT EINER ASYMMETRISCH GEFÜHRTEN LUFTSTROMKÜHLUNG**
LOW VOLTAGE SWITCHING DEVICE WITH AN ASYMMETRICALLY GUIDED AIR FLOW COOLING
APPAREIL DE COMMUTATION BASSE TENSION POURVU DE REFROIDISSEMENT DE FLUX D'AIRE GUIDÉ DE MANIÈRE ASYMÉTRIQUE

(43) Veröffentlichungstag der Anmeldung: 29.05.2019
(73) Patentinhaber: Siemens Aktiengesellschaft, 80333 München (DE)
(72) Erfinder: Käsbauer, Peter, 92421 Schwandorf (DE); Reichenbach, Norbert, 92224 Amberg (DE)

(56) Entgegenhaltungen:
- EP-A2- 1 947 920
- EP-A2- 2 229 044
- DE-A1-102004 017 292
- DE-A1-102007 057 472
- US-A1- 2009 116 189

## Beschreibung

Die Erfindung betrifft ein Niederspannungsschaltgerät mit einem Gehäuse, in welchem leistungselektronische Bauelemente im Lüftungsbereich eines Lüfters angeordnet sind.

In mehrphasigen Stromnetzen, in der ganz überwiegenden Zahl sind diese dreiphasig, werden leistungselektronische Geräte, wie z.B. Sanftstarter, zur Steuerung des Energieflusses eingesetzt. In jeder Netzphase befinden sich hierzu leistungselektronische Einheiten, auch Leistungsteile genannt, die den Stromfluss geeignet beeinflussen. Bei Sanftstartern besteht ein Leistungsteil aus zwei leistungselektronischen Bauelementen, dies sind Thyristoren in Antiparallelschaltung, welche mit Kühlmitteln wie Kühlkörpern versehen sind.

Die Kühlmittel werden benötigt, um die Verlustwärme, die durch die Stromsteuerung in den leistungselektronischen Bauelementen entsteht, von diesen wegzuführen und damit unzulässige Temperaturen in diesen zu vermeiden.

Ein weiteres Kühlmittel sind Lüfter zur Verbesserung der Wärmeabfuhr von Kühlkörpern. Diese ermöglichen einen höheren Gerätenennstrom oder auch höhere Schaltspielzahlen.

Bei Sanftstartern in dreiphasigen Drehstromnetzen werden die drei Leistungsteile häufig nahezu symmetrisch belastet, so dass in diesen ähnlich hohe Verlustleistungen und Übertemperaturen entstehen. Unterschiede in den Verlustleistungen können durch eine ungleiche Spannungshöhe der drei Netzphasenspannungen entstehen, welche ungleiche Netzphasenströme verursachen sowie durch Exemplarstreuungen beim Durchlassverhalten der leistungselektronischen Bauelemente.

Eine aus dem Stand der Technik bekannte Lösung besteht darin, jedes Leistungsteil mit einem Temperatursensor auszustatten um so jedes Leistungsteil, unabhängig von den anderen und unabhängig von der vorhandenen Verlustleistungsungleichheit, schützen zu können.

Eine weitere Lösung besteht darin, mittels thermischer Vermessung das am ungünstigsten gekühlte Leistungsteil zu ermitteln und nur dieses mit einem Temperatursensor zu versehen. Bei drei nebeneinander angeordneten Leistungsteilen und natürlicher Konvektion ist dies das mittlere, da es von seinen beiden Nachbarn mit erwärmt wird bzw. diese jeweils eine kühlere Außenseite haben. Bei erzwungener Konvektion mit Lüftern kann dies jedes der drei Leistungsteile sein, abhängig von der Rotordrehrichtung der Lüfter und der Luftstromrichtung durch die Leistungsteile hindurch.

Sollte bei Kühlung mit Lüftern eines der äußeren Leistungsteile am heißesten sein und dort der Temperatursensor angebracht werden, muss eine gewisse Temperaturreserve für den Fall eines Lüfterdefekts vorgehalten werden, da dann das mittlere Leistungsteil das wärmste wird. Ergänzend muss eine Temperaturreserve bei der Auslegung mit eingerechnet werden, um die Verlustleistungsungleichheit zu berücksichtigen. Beides hat eine gewisse Überdimensionierung der Leistungsteile zur Folge.

Eine andere Lösung ist die Anordnung aller leistungselektronischen Bauelemente auf einem gemeinsamen Kühlkörper, so dass dieser dann mit einem einzigen Temperatursensor versehen wird. Dies setzt jedoch die elektrische Isolation der Leistungsbauelemente einer Netzphase gegen die der anderen Netzphasen voraus, was thermisch nachteilig ist, so dass dies nur bis zu einer Gerätenennstromhöhe von ca. 150 - 200 A praktikabel ist.

Die EP 2 229 044 A2 beschreibt ein Schaltgerät mit einem Gehäuse, in welchem leistungselektronische Bauelemente im Lüf tungsbereich eines Lüfters angeordnet sind, wobei die leistungselektronischen Bauelemente von einem vom Lüfter ausgehend asymmetrisch geführten Luftstrom temperaturreguliert arbeiten.

Aus der EP 1 947 920 A2 geht eine Kühlanordnung für in einem Gehäuse angeordnete
elektrische Komponenten eines Sanftanlaufgerätes hervor, welches insbesondere zum Betreiben
eines Elektromotors ausgebildet ist. Die Kühlanordnung weist mindestens ein Gebläse auf, welches in einer Öffnung einer Gehäusewand schräg eingebaut ist, so dass die Drehachse α des Gebläses zur senkrechten (S) der Gehäusewand geneigt ist.

Die DE 10 2004 017 292 A1 beschreibt ein Motorsteuergerät aufweisend einen Aufbau, welcher einen unteren und einen oberen Gerätebereich aufweist, wobei im oberen Gerätebereich leistungselektronische Bauelemente angeordnet sind, wobei im Gerät eine Kühleinheit zur Aufnahme von Kühlkörpern angeordnet ist. Darüber hinaus sind Lüfter zur aktiven Kühlung des Motorsteuergeräts vorgesehen.

Aus der DE 10 2007 057 472 A1 geht ein Kühlkörper hervor, welcher die Luftgeschwindigkeit zwischen Kühlrippen gleichförmig macht, um die Leistungsfähigkeit der Wärmeabfuhr zu verbessern, wodurch eine Reduzierung des Gewichts realisiert und eine günstige Kostenrelation erzielt wird. Die distalen Enden von den Rippen, welche im Wesentlichen vor einem Kühlventilator angeordnet sind, sind an der weitesten stromaufwärts befindlichen Seite in der Strömungsrichtung der Kühlungsluft gelegen, und die distalen Enden der Rippen auf beiden Seiten in der Breitenrichtung des Kühlkörpers sind an der weitesten stromabwärts befindlichen Seite gelegen. Jede der Rippen ist vorzugsweise mit einer Schräge versehen, so dass die Höhe der jeweiligen Rippe von deren distalem Ende in einer Richtung von der Stromaufwärts-Seite zur Stromabwärts-Seite in der Strömungsrichtung der Kühlungsluft allmählich zunimmt.

Die Nachteile der aus dem Stand der Technik bekannten Lösungen bestehen darin, dass entweder mehrere Temperatursensoren verwendet werden oder konstruktiv zusätzlicher Bauraum für Kühlelemente eingeplant werden muss.

Demgemäß besteht die Aufgabe der vorliegenden Erfindung darin, ein Niederspannungsschaltgerät, insbesondere einen Sanftstarter, zu schaffen, welches auch bei Gerätenennströmen im Bereich bis 650 A eine zuverlässige Temperaturregulierung der leistungselektronischen Bauelemente ermöglicht.

Diese Aufgabe wird erfindungsgemäß durch ein Niederspannungsschaltgerät mit den Merkmalen des Patentanspruchs 1 gelöst. Vorteilhafte Aus- und Weiterbildungen, welche einzeln oder in Kombination miteinander eingesetzt werden können, sind der Gegenstand der abhängigen Ansprüche.

Erfindungsgemäß wird diese Aufgabe durch ein Niederspannungsschaltgerät mit einem Gehäuse gelöst, in welchem leistungselektronische Bauelemente im Lüftungsbereich eines Lüfters angeordnet sind. Die Erfindung zeichnet sich dadurch aus, dass die leistungselektronischen Bauelemente von einem vom Lüfter ausgehend asymmetrisch geführten Luftstrom temperaturreguliert arbeiten, so dass das Niederspannungsschaltgerät mit einem Gerätenennstrombereich bis 650 A durch diesen asymmetrisch geführten Luftstrom zu betreiben ist.

Die erfindungsgemäße Lösung sieht die Verwendung nur eines einzigen Lüfters für die Kühlung aller leistungstungselektronischen Bauelemente vor. Jedem Leistungsteil wird konstruktiv ein separater Luftkanal zugeordnet. Der Querschnitt der einzelnen Luftkanäle wird individuell an geeigneter Stelle so angepasst, dass bei gleicher Verlustleistungsentstehung das mittlere Leistungsteil etwas schlechter durchströmt und damit etwas wärmer ist als die beiden äußeren Leistungsteile, wobei die beiden äußeren Leistungsteile in etwa gleich warm sind.

Der Luftkanal für das mittlere Leistungsteil weist am Luftaustritt eine Verengung auf. Weitere Strömungshindernisse können im Lufteintrittsbereich dieses Luftkanals am Boden, seitlich und oberhalb der Leistungsteile angebracht sein. Diese Strömungskanalanpassungen bewirken die geringere Durchströmung des mittleren Kanals, der strömungstechnisch am günstigsten liegt.

Unterschiedlich große Öffnungen stellen eine in etwa gleiche Durchströmung bzw. Kühlwirkung für die beiden äußeren Leistungsteile sicher. Hier ist das äußere Leistungsteil bzw. der außen liegende Luftkanal im Vorteil, bedingt durch die Rotationsrichtung des Lüfterrotors. Deshalb ist der Luftdurchtritt im Mittelbereich kleiner als der Luftdurchtritt im äußeren Randbereich.

Ein Temperatursensor wird auf das mittlere, etwas wärmere Leistungsteil platziert. Die Asymmetrie in der Luftführung wird in etwa so hoch eingestellt, dass der Großteil der zu erwartenden Verlustleistungsungleichheiten dadurch aufgefangen wird. Damit wird auch für den Fall, dass in den beiden äußeren Leistungsteilen mehr Verlustleistung entsteht, sichergestellt, dass diese nicht wärmer sind als das mittlere Leistungsteil und damit dessen Temperatursensor auch die beiden äußeren Leistungsteile schützt.

Der große Vorteil der hier vorgestellten Lösung besteht darin, dass nur ein einziger Lüfter benötigt wird. Der Fertigungsaufwand ist dadurch erheblich geringer, da nur ein Lüfter montiert und mittels Stecker auf einer Flachbaugruppe angesteckt werden muss. Auf der Flachbaugruppe entfällt so ein weiterer Stecker. Es wird zudem ein sehr robustes Geräteverhalten erzielt. Sollte der Lüfter in seiner Funktion beeinträchtigt sein oder sogar ausfallen, wird das mittlere, überwachte Leistungsteil am heißesten werden, so dass die beiden äußeren Leistungsteile automatisch geschützt sind.

Es wird außerdem nur ein einziger Temperatursensor benötigt. Da der Temperatursensor auf dem mittleren Leistungsteil in den allermeisten Fällen die höchste Temperatur aller drei Leistungsteile aufweist, sind auch die Leistungsteile ohne Temperatursensor geschützt. Es werden zwei Temperatursensoren gespart einschließlich des Anschraubens auf dem Leistungsteil und dem Anstecken auf der Flachbaugruppe. Ebenso entfallen die Stecker auf der Flachbaugruppe sowie die zugehörigen elektronischen Auswertebaugruppen.
In einer besonders vorteilhaften Ausgestaltung der Erfindung kann es vorgesehen sein, dass im Niederspannungsschaltgerät nur ein luftstromanziehender Lüfter angeordnet ist und ein zweiter Lüfter durch definiert geführte asymmetrisch ausgebildete Teilluftströme ersetzt ist.

Erfindungsgemäss sind die leistungselektronischen Bauelemente parallel in Kammern nebeneinander angeordnet, so dass der vom Lüfter ausgehende Luftstrom in asymmetrisch geführte Teilluftströme aufgeteilt ist.

Weiterhin ist vorgesehen, dass jedem leistungselektronischen Bauelement ein separater Teilluftstrom zugeordnet ist, wobei der Querschnitt der separaten Teilluftströme unterschiedlich ausgebildet ist, so dass bei einer gleich ausgebildeten Verlustleistung der einzelnen leistungselektronischen Bauelemente ein leistungselektronisches Bauelement schlechter vom dazugehörigen Teilluftstrom gekühlt wird und somit wärmer ist als die beiden anderen leistungselektronischen Bauelemente.

Es hat sich dabei als vorteilhaft erwiesen, dass das wärmere leistungselektronische Bauelement mit einem Luftkanal für den dazugehörigen Teilluftstrom ausgebildet ist, in welchem durch Luftleitwände ein Strömungshindernis ausgebildet ist.

Eine erfindungsgemäße Weiterführung dieses Konzepts kann vorsehen, dass das wärmere leistungselektronische Bauelement mit einem Luftkanal für den dazugehörigen Teilluftstrom ausgebildet ist, in welchem durch eine podestähnliche Erhebung am Gehäuseboden des Niederspannungsschaltgerät ein Strömungshindernis ausgebildet ist.

Zudem entspricht es einer Fortführung des erfindungsgemäßen Konzepts, wenn das wärmere leistungselektronische Bauelement mit einem Luftkanal für den dazugehörigen Teilluftstrom ausgebildet ist, in welchem durch einen Versatz der parallel zum leistungselektronischen Bauelement ausgebildeten Teilungswände im Gehäuse des Niederspannungsschaltgeräts ein Strömungshindernis ausgebildet ist.

In einer besonders vorteilhaften Ausgestaltung der Erfindung kann es vorgesehen sein, dass das wärmere leistungselektronische Bauelement mit einem Luftkanal für den dazugehörigen Teilluftstrom ausgebildet ist, in welchem durch einen Vorsprung an der Gehäuseoberseite ein Strömungshindernis ausgebildet ist.

Erfindungsgemäss ist das wärmere leistungselektronische Bauelement zentral vor dem Lüfter angeordnet, wobei der zu diesem Bauelement gehörige Teilluftstrom durch sich gegenüberliegende Teilwände am Anfang des Luftkanal geführt ist.

In einer weiteren speziellen Fortführung des erfindungsgemäßen Konzepts kann es vorgesehen sein, dass die leistungselektronischen Bauelemente neben dem zentral vor dem Lüfter angeordneten leistungselektronischen Bauelement positioniert sind, wobei der zu diesen Bauelementen gehörige Teilluftstrom durch Luftleitwände am Anfang des Luftkanals geführt ist.

Erfindungsgemäss ist das wärmere leistungselektronische Bauelement mit einem Temperatursensor versehen.
Eine erfindungsgemäße Weiterführung dieses Konzepts kann vorsehen, dass die Asymmetrie in der Luftführung durch die leistungselektronischen Bauelemente derart ausgebildet ist, dass der Großteil der zu erwartenden Verlustleistungsungleichheiten dadurch reguliert wird, so dass der einzige Temperatursensor ein Kontrollmedium für alle leistungselektronischen Bauelemente ist.

Zudem entspricht es einer Fortführung des erfindungsgemäßen Konzepts, wenn das Niederspannungsschaltgerät ein Sanftstarter ist.

Das erfindungsgemäße Niederspannungsschaltgerät weist vorzugsweise ein quaderförmiges Gehäuse auf mit einer Gehäuseunterseite, auf welcher vier Seitenwände in einem Winkel von 90° zueinander angeordnet und welche von einer Gehäuseoberseite abgeschlossen werden. Das Niederspannungsschaltgerät kann innerhalb des Gehäuses in drei Gehäusebereiche unterteilt sein, insbesondere einem unteren, mittleren und einem oberen Bereich. Vorzugsweise im unteren Gehäusebereich kann ein Lüfter angeordnet sein, welcher innerhalb einer Seitenwand positioniert ist. Innenseitig ist der Bereich nach dem Lüfter im Gehäuse in vorzugsweise drei Kammern aufgeteilt. Diese Aufteilung ist vorzugsweise durch eingezogene Teilungswände im Gehäuseinneren umgesetzt. Die sich dadurch bildenden Kammern sind zwischen zwei sich gegenüberliegenden Seitenwänden des Gehäuses ausgebildet und zwar derart, dass darin positionierte leistungselektronische Bauelemente parallel zueinander und in Längsrichtung zur Strömungsrichtung der Luftkanäle, welche durch den Lüfter mit kühlender Luft versorgt werden, ausgerichtet sind. Die leistungselektronischen Bauelemente sind vorzugsweise quaderförmig ausgebildet mit vier Seitenwänden, einer Oberseite sowie einer Unterseite.

Die mittlere Kammer ist direkt nach dem Lüfter, also zentral, in Luftströmungsrichtung positioniert. Die anderen beiden Kammern sind jeweils an den sich gegenüberliegenden äußeren Seitenwänden des Gehäuses des Niederspannungsschaltgeräts angeordnet. Im Anschluss an den Lüfter sind jeweils als Bestandteil für die nachgeordneten Kammern Teilwände in Form von Luftleitwänden für die Luftdurchströmung angeordnet. Bei der mittleren Kammer sind dafür vorzugsweise zwei sich gegenüberliegende Luftleitwände ausgebildet. Für die äußeren Kammern wurde vorzugsweise jeweils eine Luftleitwand, welche von den jeweiligen Seitenwänden des Gehäuses nach innen gezogen ausgebildet ist, positioniert.

Die parallel ausgebildeten Teilungswände der mittleren Kammer sind vorzugsweise nach den Luftleitwänden in Luftströmungsrichtung versetzt ausgebildet, derart, dass sie zwar weiterhin parallel zu den Seitenwänden des Gehäuses verlaufen, aber unter Beibehaltung des Abstands zueinander näher zu einer der beiden Seitenwänden ausgerichtet sind. Diese Teilungswände der mittleren Kammer sind an der gegenüberliegenden Seite zu den Luftleitwänden aufeinander zugerichtet ausgebildet, vorzugsweise mit einem Winkel von ca. 10 bis 20°.

Die Luftleitwände der äußeren Kammern definieren jeweils seitlich neben dem zentral positionierten Lüfter Luftschächte, welche durch vorzugsweise parallel zueinander ausgerichtete nach innen gerichtete Luftleitwände an der Seitenwand, in welcher der Lüfter integriert ist, weiter unterteilt werden und definierte Luftkanäle ausbilden.

Weitere Strömungshindernisse sind im Lufteintrittsbereich dieses mittleren Luftkanals am Boden, seitlich und oberhalb der leistungselektronischen Bauelemente angebracht. Diese Strömungskanalanpassungen bewirken die geringere Durchströmung des mittleren Kanals, der strömungstechnisch am günstigsten liegt.

Unterschiedlich große Öffnungen stellen eine in etwa gleiche Durchströmung bzw. Kühlwirkung für die beiden äußeren Leistungsteile sicher. Hier ist das äußere Leistungsteil bzw. der außen liegende Luftkanal im Vorteil, bedingt durch die Rotationsrichtung des Lüfterrotors. Deshalb ist der Luftdurchtritt im Mittelbereich kleiner als der Luftdurchtritt im äußeren Randbereich.

Weitere Vorteile und Ausführungen der Erfindung werden nachfolgend anhand eines Ausführungsbeispiels sowie anhand der Zeichnung näher erläutert.

Dabei zeigen:
- Fig. 1: in einer Draufsicht ein erfindungsgemäßer Gerätebereich eines Niederspannungsschaltgeräts mit nur einem Lüfter und einer definierten Ausbildung der Luftdurchströmungskanäle für nachgeschaltete leistungselektronische Bauelemente;
- Fig. 2: in einer Draufsicht die Darstellung nach Fig. 1 ohne leistungselektronische Bauelemente.

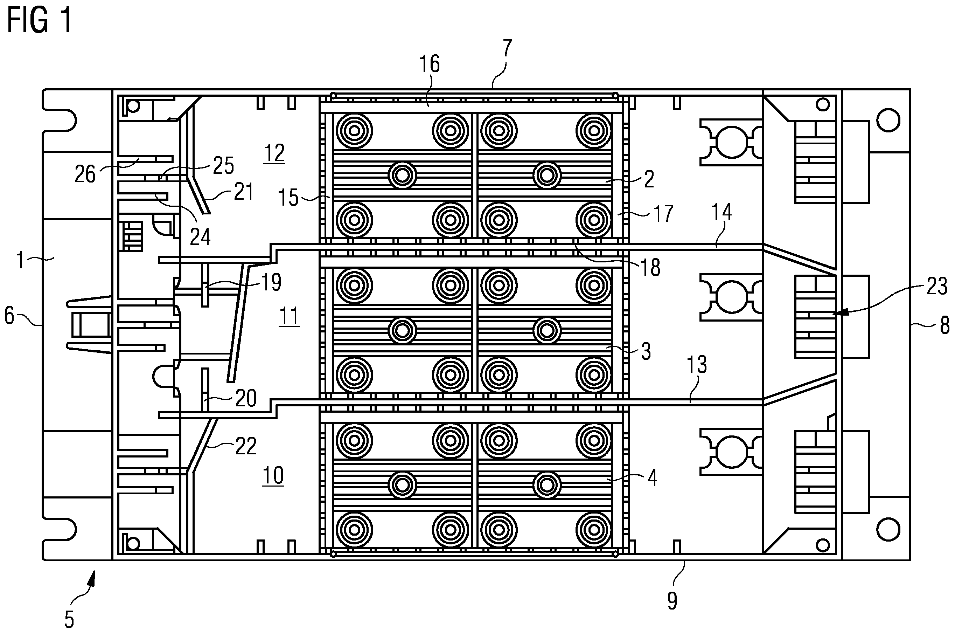

Fig. 1 zeigt einen erfindungsgemäßen Gerätebereich eines Niederspannungsschaltgeräts mit nur einem Lüfter 1 und einer definierten Ausbildung der Luftdurchströmungskanäle für nachgeschaltete leistungselektronische Bauelemente 2, 3, 4.

Das erfindungsgemäße Niederspannungsschaltgerät weist vorzugsweise ein quaderförmiges Gehäuse 5 auf mit einer Gehäuseunterseite, auf welcher vier Seitenwände 6, 7, 8, 9 in einem Winkel von 90° zueinander angeordnet und welche von einer Gehäuseoberseite abgeschlossen werden. Das Niederspannungsschaltgerät kann innerhalb des Gehäuses 5 in drei Gehäusebereiche unterteilt sein, insbesondere einem unteren, mittleren und einem oberen Bereich. Vorzugsweise im unteren Gehäusebereich kann der Lüfter 1 angeordnet sein, welcher innerhalb der Seitenwand 6 positioniert ist. Innenseitig ist der Bereich nach dem Lüfter 1 im Gehäuse 5 in vorzugsweise drei Kammern 10, 11, 12 aufgeteilt. Diese Aufteilung ist durch eingezogene Teilungswände 13, 14 im Gehäuseinneren umgesetzt. Die sich dadurch bildenden Kammern 10, 11, 12 sind zwischen zwei sich gegenüberliegenden Seitenwänden 7, 9 des Gehäuses 5 ausgebildet und zwar derart, dass darin positionierte leistungselektronische Bauelemente 2, 3, 4 parallel zueinander und in Längsrichtung zur Strömungsrichtung der Luftkanäle, welche durch den Lüfter 1 mit kühlender Luft versorgt werden, ausgerichtet sind. Die leistungselektronischen Bauelemente 2, 3, 4 sind vorzugsweise quaderförmig ausgebildet mit vier Seitenwänden 15, 16, 17, 18 einer Oberseite sowie einer Unterseite.

Die mittlere Kammer 11 ist direkt nach dem Lüfter 1, also zentral, in Luftströmungsrichtung positioniert. Die anderen beiden Kammern 10, 12 sind jeweils an den sich gegenüberliegenden äußeren Seitenwänden 7, 9 des Gehäuses 5 des Niederspannungsschaltgeräts angeordnet. Im Anschluss an den Lüfter 1 sind jeweils als Bestandteil für die nachgeordneten Kammern 10, 11, 12 Teilwände 19, 20, 21, 22 in Form von Luftleitwänden für die Luftdurchströmung angeordnet. Bei der mittleren Kammer 11 sind dafür vorzugsweise zwei sich gegenüberliegende Luftleitwände 19, 20 ausgebildet. Für die äußeren Kammern 10, 12 wurde vorzugsweise jeweils eine Luftleitwand 21, 22, welche von den jeweiligen Seitenwänden 7, 9 des Gehäuses nach innen gezogen sind, positioniert.

Die parallel ausgebildeten Teilungswände 13, 14 der mittleren Kammer 11 sind vorzugsweise nach den Luftleitwänden in Luftströmungsrichtung versetzt ausgebildet, derart, dass sie zwar weiterhin parallel zu den Seitenwänden 7, 9 des Gehäuses 5 verlaufen, aber unter Beibehaltung des Abstand zueinander näher zu einer der beiden Seitenwänden 7, 9 ausgerichtet sind. Diese Teilungswände 13, 14 der mittleren Kammer 11 sind an der gegenüberliegenden Seite zu den Luftleitwänden aufeinander zugerichtet ausgebildet, vorzugsweise mit einem Winkel von ca. 10 bis 20°, so dass sich eine Verengung 23 ausbildet.

Weitere Strömungshindernisse sind im Lufteintrittsbereich dieses Luftkanals am Boden, seitlich und oberhalb der Leistungsteile 2, 3, 4 angebracht. Diese Strömungskanalanpassungen bewirken die geringere Durchströmung des mittleren Kanals 11, der strömungstechnisch am günstigsten liegt. Unterschiedlich große Öffnungen stellen eine in etwa gleiche Durchströmung bzw. Kühlwirkung für die beiden äußeren leistungselektronische Bauelemente 2, 4 sicher. Hier ist das äußere leistungselektronische Bauelement 2, 4 bzw. der außen liegende Luftkanal im Vorteil, bedingt durch die Rotationsrichtung des Lüfterrotors. Deshalb ist der Luftdurchtritt im Mittelbereich kleiner als der Luftdurchtritt im äußeren Randbereich.

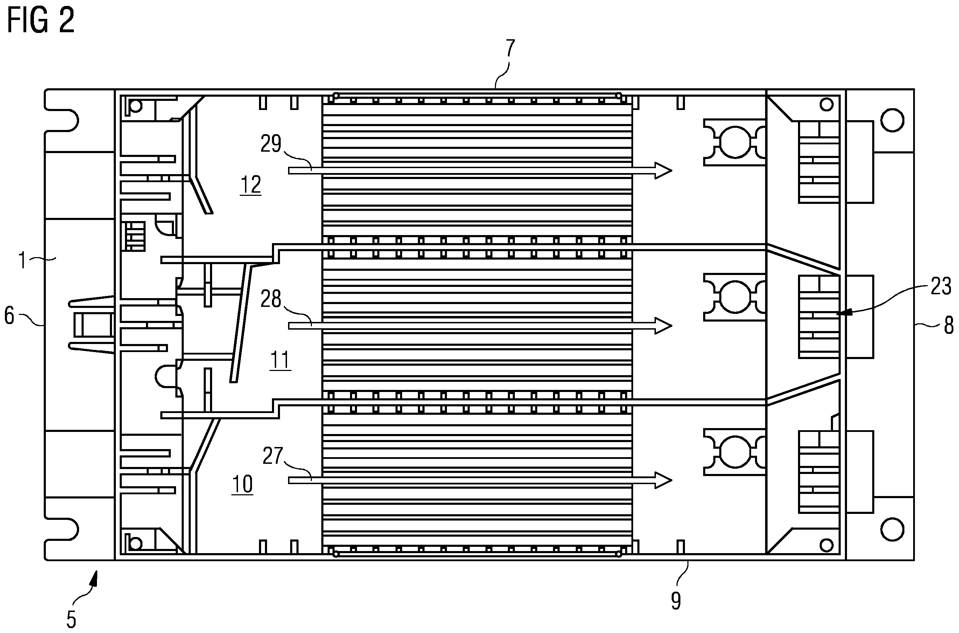

In Fig. 2 ist der Gerätebereich nach Fig. 1 ohne die leistungselektronischen Bauelemente 2, 3, 4 dargestellt. Die in Pfeilrichtung dargestellten Teilluftstrome 27, 28, 29 in den drei Kammern 10, 11, 12 sind hinsichtlich ihrer Intensität unterschiedlich ausgebildet.

Ein Temperatursensor wird auf das mittlere, etwas wärmere leistungselektronische Bauelement 3 platziert. Die Asymmetrie in der Luftführung wird in etwa so hoch eingestellt, dass der Großteil der zu erwartenden Verlustleistungsungleichheiten dadurch aufgefangen wird. Damit wird auch für den Fall, dass in den beiden äußeren leistungselektronische Bauelemente 2, 4 mehr Verlustleistung entsteht, sichergestellt, dass diese nicht wärmer sind als das mittlere leistungselektronische Bauelement 3 und damit dessen Temperatursensor auch die beiden äußeren leistungselektronische Bauelemente 2, 4 schützt.

Der große Vorteil der hier vorgestellten Lösung besteht darin, dass nur ein einziger Lüfter 1 benötigt wird. Der Fertigungsaufwand ist geringer, da nur ein Lüfter 1 montiert und mittels Stecker auf einer Flachbaugruppe angesteckt werden muss. Auf der Flachbaugruppe entfällt so ein weiterer Stecker. Es wird zudem ein sehr robustes Geräteverhalten erzielt. Sollte der Lüfter 1 in seiner Funktion beeinträchtigt sein oder sogar ausfallen, wird das mittlere, überwachte leistungselektronische Bauelement 3 am heißesten werden, so dass die beiden äußeren leistungselektronischen Bauelemente 2, 4 automatisch geschützt sind.

Es wird außerdem nur ein einziger Temperatursensor benötigt. Da der Temperatursensor auf dem mittleren leistungselektronische Bauelement 3 in den allermeisten Fällen die höchste Temperatur aller drei leistungselektronischen Bauelemente 2, 3, 4 aufweist, sind auch die leistungselektronische Bauelemente 2, 4 ohne Temperatursensor geschützt. Es werden zwei Temperatursensoren gespart einschließlich des Anschraubens auf dem Leistungsteil und dem Anstecken auf der Flachbaugruppe. Ebenso entfallen die Stecker auf der Flachbaugruppe sowie die zugehörigen elektronischen Auswertebaugruppen.

Der erfindungsgemäße Niederspannungsschaltgerät zeichnet sich dadurch aus, dass auch bei Gerätenennströmen im Bereich bis 650 A eine zuverlässige Temperaturregulierung der leistungselektronischen Bauelemente realisierbar ist.

### Bezugszeichenliste

- 1: Lüfter
- 2: leistungselektronisches Bauelement
- 3: leistungselektronisches Bauelement
- 4: leistungselektronisches Bauelement
- 5: Gehäuse
- 6: Seitenwand
- 7: Seitenwand
- 8: Seitenwand
- 9: Seitenwand
- 10: Kammer
- 11: Kammer
- 12: Kammer
- 13: Teilungswand
- 14: Teilungswand
- 15: Seitenwand
- 16: Seitenwand
- 17: Seitenwand
- 18: Seitenwand
- 19: Luftleitwand
- 20: Luftleitwand
- 21: Luftleitwand
- 22: Luftleitwand
- 23: Verengung
- 27: Teilluftstrom
- 28: Teilluftstrom
- 29: Teilluftstrom

## Patentansprüche

1. Niederspannungsschaltgerät mit einem Gehäuse (5), in welchem leistungselektronische Bauelemente (2, 3, 4) im Lüftungsbereich eines Lüfters (1) angeordnet sind, wobei die leistungselektronischen Bauelemente (2, 3, 4) von einem vom Lüfter (1) ausgehend asymmetrisch geführten Luftstrom temperaturreguliert arbeiten, wobei die leistungselektronischen Bauelemente (2, 3, 4) parallel nebeneinander in Kammern (10, 11, 12) angeordnet sind, so dass der vom Lüfter (1) ausgehende Luftstrom in asymmetrisch geführte Teilluftströme aufgeteilt ist, wobei jedem leistungselektronischen Bauelement (2, 3, 4) ein separater Teilluftstrom (27, 28, 29) zugeordnet ist, wobei der Querschnitt der separaten Teilluftströme (27, 28, 29) unterschiedlich ausgebildet ist, so dass bei einer gleich ausgebildeten Verlustleistung der einzelnen leistungselektronischen Bauelemente (2, 3, 4) ein leistungselektronisches Bauelement (3) schlechter vom dazugehörigen Teilluftstrom (28) gekühlt wird und somit wärmer ist als die beiden anderen leistungselektronischen Bauelemente (2, 4), so dass das Niederspannungsschaltgerät mit einem Gerätenennstrombereich bis 650 A durch diesen asymmetrisch geführten Luftstrom zu betreiben ist, wobei das wärmere leistungselektronische Bauelement (3) zentral vor dem Lüfter (1) angeordnet ist, wobei der zu diesem Bauelement (3) gehörige Teilluftstrom (28) durch sich gegenüberliegende Luftleitwände (19, 20) am Anfang des Luftkanals geführt ist, wobei das wärmere leistungselektronische Bauelement (3) mit einem Temperatursensor versehen ist und wobei die Asymmetrie in der Luftführung so eingestellt wird, dass in dem Fall, dass aufgrund von Verlustleistungsungleichheiten in den beiden äußeren leistungselektronischen Bauelementen(2,4) mehr Verlustleistung entsteht, sichergestellt ist, dass diese nicht wärmer sind als das mittlere leistungselektronische Bauelement (3).

2. Niederspannungsschaltgerät nach Anspruch 1, **dadurch gekennzeichnet, dass** das wärmere leistungselektronische Bauelement (3) mit einem Luftkanal für den dazugehörigen Teilluftstrom (28) ausgebildet ist, in welchem durch Luftleitwände (19, 20) ein Strömungshindernis ausgebildet ist.

3. Niederspannungsschaltgerät nach Anspruch 1 oder 2, **dadurch gekennzeichnet, dass** das wärmere leistungselektronische Bauelement (3) mit einem Luftkanal für den dazugehörigen Teilluftstrom (28) ausgebildet ist, in welchem durch eine podestähnliche Erhebung am Gehäuseboden des Niederspannungsschaltgerät ein Strömungshindernis ausgebildet ist.

4. Niederspannungsschaltgerät nach einem der Ansprüche 1 bis 3, **dadurch gekennzeichnet, dass** das wärmere leistungselektronische Bauelement (3) mit einem Luftkanal für den dazugehörigen Teilluftstrom (28) ausgebildet ist, in welchem durch einen Versatz der parallel zum leistungselektronischen Bauelement (3) ausgebildeten Teilungswände (13, 14) im Gehäuse (5) des Niederspannungsschaltgeräts ein Strömungshindernis ausgebildet ist, wobei die parallel ausgebildeten Teilungswände (13, 14) der mittleren Kammer vorzugsweise nach den Luftleitwänden in Luftströmungsrichtung versetzt ausgebildet sind, derart, dass sie zwar weiterhin parallel zu den Seitenwänden (7,9) des Gehäuses (5) verlaufen, aber unter Beibehaltung des Abstand zueinander näher zu einer der beiden Seitenwände (7, 9) ausgerichtet sind.

5. Niederspannungsschaltgerät nach einem der Ansprüche 1 bis 4, da durch gekennzeichnet, dass das wärmere leistungselektronische Bauelement (3) mit einem Luftkanal für den dazugehörigen Teilluftstrom (28) ausgebildet ist, in welchem durch einen Vorsprung an der Gehäuseoberseite ein Strömungshindernis ausgebildet ist.

6. Niederspannungsschaltgerät nach einem der Ansprüche 1 bis 5, **dadurch gekennzeichnet, dass** die leistungselektronischen Bauelemente (2, 4) neben dem zentral vor dem Lüfter (1) angeordneten leistungselektronischen Bauelement (3) positioniert sind, wobei der zu diesen Bauelementen (2, 4) gehörigen Teilluftstrom (27, 29) durch eine Luftleitwand (21, 22) am Anfang des Luftkanals geführt ist.

7. Niederspannungsschaltgerät nach Anspruch 1, **dadurch gekennzeichnet, dass** die Asymmetrie in der Luftführung durch die leistungselektronischen Bauelemente (2, 3, 4) derart ausgebildet ist, dass der Großteil der zu erwartenden Verlustleistungsungleichheiten dadurch reguliert wird, so dass der einzige Temperatursensor auch ein Kontrollmedium für alle leistungselektronischen Bauelemente (2, 3, 4) ist, wobei die Asymmetrie in der Luftführung so eingestellt wird, dass in dem Fall, dass aufgrund von Verlustleistungsungleichheiten in den beiden äußeren Leistungsteilen mehr Verlustleistung entsteht, sichergestellt ist, dass diese nicht wärmer sind als das mittlere Leistungsteil.

8. Niederspannungsschaltgerät nach einem der Ansprüche 1 bis 7, **dadurch gekennzeichnet, dass** das Niederspannungsschaltgerät ein Sanftstarter ist.

## Claims

1. Low-voltage switching device comprising a housing (5) in which power electronic components (2, 3, 4) are arranged in the region of ventilation of a fan (1),
wherein the power electronic components (2, 3, 4) operate under temperature regulation by virtue of an air flow that originates from the fan (1) and is guided asymmetrically,
wherein the power electronic components (2, 3, 4) are arranged parallel beside one another in chambers (10, 11, 12), so that the air flow originating from the fan (1) is divided into two asymmetrically guided partial air flows,
wherein each power electronic component (2, 3, 4) is assigned a separate partial air flow (27, 28, 29),
wherein the cross section of the separate partial air flows (27, 28, 29) is formed differently, so that in the event of an equal power loss of the individual power electronic components (2, 3, 4), one power electronic component (3) is cooled more poorly by the associated partial air flow (28) and is thus warmer than the two other power electronic components (2, 4), so that the low-voltage switching device can be operated with a nominal device current range of up to 650 A as a result of this asymmetrically guided air flow,
wherein the warmer power electronic component (3) is arranged centrally in front of the fan (1),
wherein the partial air flow (28) belonging to this component (3) is guided by opposite air guide walls (19, 20) at the start of the air channel,
wherein the warmer power electronic component (3) is provided with a temperature sensor, and
wherein the asymmetry in the air guidance is adjusted such that, in the case in which a higher power loss is produced in the two outer power electronic components (2, 4) on account of power-loss inequalities, it is ensured that these are no warmer than the central power electronic component (3).

2. Low-voltage switching device according to Claim 1, **characterized in that** the warmer power electronic component (3) is formed with an air channel for the associated partial air flow (28), in which a flow obstacle is formed by air guide walls (19, 20).

3. Low-voltage switching device according to Claim 1 or 2, **characterized in that** the warmer power electronic component (3) is formed with an air channel for the associated partial air flow (28), in which a flow obstacle is formed by a pedestal-like elevation on the housing bottom of the low-voltage switching device.

4. Low-voltage switching device according to one of Claims 1 to 3, **characterized in that** the warmer power electronic component (3) is formed with an air channel for the associated partial air flow (28), in which a flow obstacle is formed by an offset of the dividing walls (13, 14) in the housing (5) of the low-voltage switching device, formed parallel to the power electronic component (3), wherein the parallel dividing walls (13, 14) of the central chamber downstream of the air guide walls are preferably offset in the air flow direction in such a way that although they continue to extend parallel to the side walls (7, 9) of the housing (5), they are aligned closer to one of the two side walls (7, 9) but while maintaining the distance from each other.

5. Low-voltage switching device according to one of Claims 1 to 4, **characterized in that** the warmer power electronic component (3) is formed with an air channel for the associated partial air stream (28), in which a flow obstacle is formed by a projection on the housing upper side.

6. Low-voltage switching device according to one of Claims 1 to 5, **characterized in that** the power electronic components (2, 4) are positioned beside the power electronic component (3) arranged centrally in front of the fan (1), wherein the partial air stream (27, 29) belonging to these components (2, 4) is guided by an air guide wall (21, 22) at the start of the air channel.

7. Low-voltage switching device according to Claim 1, **characterized in that** the asymmetry in the air guidance through the power electronic components (2, 3, 4) is formed in such a way that the major part of the power-loss inequalities to be expected is regulated as a result, so that the single temperature sensor is also a control medium for all of the power electronic components (2, 3, 4), wherein the asymmetry in the air guidance is adjusted such that, in the case in which a higher power loss is produced in the two outer power parts on account of power-loss inequalities, it is ensured that these are no warmer than the central power part.

8. Low-voltage switching device according to one of Claims 1 to 7, **characterized in that** the low-voltage switching device is a soft-starter.

## Revendications

1. Appareil de coupure de basse tension, comprenant un boîtier (5), dans lequel des composants (2, 3, 4) d'électronique de puissance sont disposés dans la région de ventilation d'un ventilateur (1), les composants (2, 3, 4) d'électronique de puissance fonctionnant de manière régulée en température par un courant d'air conduit dissymétriquement à partir du ventilateur (1), des composants (2, 3, 4) d'électronique de puissance étant disposés dans des chambres (10, 11, 12) les uns à côté des autres en parallèle, de manière à répartir le courant d'air provenant du ventilateur (1) en des sous-courants d'air conduits de manière dissymétrique, dans lequel, à chaque composant (2, 3, 4) d'électronique de puissance, est associé un sous-courant (27, 28, 29) d'air distinct, la section transversale des sous-courants (27, 28, 29) d'air distincts étant constituée de manière différente, de manière à ce que, pour une puissance perdue constituée pareillement des divers composants (2, 3, 4) d'électronique de puissance, un composant (3) d'électronique de puissance soit refroidi moins bien par le sous-courant (28) d'air associé et, ainsi, soit plus chaud que les deux autres composants (2, 4) d'électronique de puissance, de manière à ce que l'appareil de coupure de basse tension puisse fonctionner en ayant une plage de courant d'appareil allant jusqu'à 650 A par ce courant d'air conduit dissymétriquement, dans lequel le composant (3) électronique de puissance le plus chaud est disposé centralement devant le ventilateur (1), dans lequel le sous-courant (28) d'air associé à ce composant (3) est conduit, par des parois (19, 20) d'acheminement d'air opposées, au début du conduit pour de l'air, dans lequel le composant (3) d'électronique de puissance plus chaud est pourvu d'une sonde de température et dans lequel la dissymétrie dans la conduite de l'air est réglée, de manière à ce que, dans le cas où, en raison d'une inégalité de perte de puissance dans les deux composants (2, 4) d'électronique de puissance extérieurs, il se crée plus de perte de puissance, il soit assuré que ceux-ci ne sont pas plus chauds que le composant (3) d'électronique de puissance médian.

2. Appareil de coupure de basse tension suivant la revendication 1, **caractérisé en ce que** le composant (3) d'électronique de puissance plus chaud est constitué en ayant un conduit pour de l'air pour le sous-courant (28) d'air associé, dans lequel un obstacle à l'écoulement est constitué par des parois (19, 20) d'acheminement de l'air.

3. Appareil de coupure de basse tension suivant la revendication 1 ou 2, **caractérisé en ce que** le composant (3) d'électronique de puissance plus chaud est constitué en ayant un conduit pour de l'air pour le sous-courant (28) d'air associé, dans lequel il est constitué, par une surélévation analogue à une plateforme au fond du boîtier de l'appareil de coupure de basse tension, un obstacle à l'écoulement.

4. Appareil de coupure de basse tension suivant l'une des revendications 1 à 3, **caractérisé en ce que** le composant (3) d'électronique de puissance plus chaud est constitué en ayant un conduit pour de l'air pour le sous-courant (28) d'air associé, dans lequel, par un décalage des parois (13, 14) de séparation constituées parallèlement au composant (3) d'électronique de puissance du boîtier (5) de l'appareil de coupure de basse tension, un obstacle à l'écoulement, les parois (13, 14) de séparation constituées parallèlement de la chambre médiane étant constituées de manière décalée, de préférence après les parois d'acheminement d'air dans le sens d'écoulement de l'air, de manière à ce qu'elles s'étendent, certes davantage parallèlement vers les parois (7, 9) latérales du boîtier (5), mais en étant dirigées en se rapprochant vers l'une des deux parois (7, 9) latérales, tout en conservant la distance entre elles.

5. Appareil de coupure de basse tension suivant l'une des revendications 1 à 4, **caractérisé en ce que** le composant (3) d'électronique de puissance plus chaud est constitué en ayant un conduit pour de l'air pour le sous-courant (28) d'air associé, dans lequel, par une saillie sur le côté supérieur du boîtier, il est constitué un obstacle à l'écoulement.

6. Appareil de coupure de basse tension suivant l'une des revendications 1 à 5, **caractérisé en ce que** les composants (2, 4) d'électronique de puissance sont placés à côté du composant (3) d'électronique de puissance disposé centralement devant le ventilateur (1), le sous-courant (27, 28) d'air associé à ces composants (2, 4) étant conduit au début du conduit pour de l'air par une paroi (21, 22) d'acheminement de l'air.

7. Appareil de coupure de basse tension suivant la revendication 1, **caractérisé en ce que** la dissymétrie dans la conduite de l'air par les composants (2, 3, 4) d'électronique de puissance est constituée de manière à ce que la partie la plus grande des inégalités de perte de puissance escomptées est régulée par le fait que la sonde unique de température est aussi un moyen de contrôle de tous les composants (2, 3, 4) d'électronique de puissance, la dissymétrie dans la conduite de l'air étant réglée de manière à ce que, dans le cas où, en raison d'inégalité de perte de puissance dans les deux parties de puissance extérieures, il se crée plus de perte de puissance, il soit assuré que celles-ci ne sont pas plus chaudes que la partie de puissance médiane.

8. Appareil de coupure de basse tension suivant l'une des revendications 1 à 7, **caractérisé en ce que** l'appareil de coupure de basse tension est un démarreur doux.
